# EUROPEAN PATENT APPLICATION

(11) **EP 4 099 375 A1**
(43) Date of publication of application: **07.12.2022**
(21) Application number: 21747526.8
(22) Date of filing: 22.01.2021
(51) Int. Cl.: H01L 23/02, H01L 23/13, H01L 23/12, H01L 23/36, H01L 33/48

(54) **ELECTRONIC COMPONENT MOUNTING PACKAGE AND ELECTRONIC DEVICE**

(30) Priority: 28.01.2020 JP 2020011715
(71) Applicant: Kyocera Corporation, Kyoto-shi Kyoto 612-8501 (JP)
(72) Inventor: SUGAI,Kouichirou, Kyoto-shi, Kyoto 612-8501 (JP); NISHIMOTO,Kazuki, Kyoto-shi, Kyoto 612-8501 (JP)
(74) Representative: Viering, Jentschura & Partner mbB Patent- und Rechtsanwälte
(86) International application number: PCT/JP2021/002225
(87) International publication number: WO 2021/153450

(57) **Abstract**

An electronic component mounting package 1 includes a metal substrate 11 having a recessed portion 12 and an insulation substrate 21 having a mounting surface for an electronic component 2, in which the insulation substrate 21 is located on a bottom surface 12a of the recessed portion 12 via a bonding material 31, and the bonding material 31 is located within the insulation substrate 21 when seen through an opening of the recessed portion 12 in front perspective view.

## Description

### Technical Field

The present disclosure relates to an electronic component mounting package and an electronic device.

### Background Art

In the case where a light emitting element is used as an electronic component, a substrate for mounting an electronic component having a recessed portion has been used (see, for example, JP 2013-122189 A).

### Summary

An electronic component mounting package of the present disclosure includes a metal substrate having a recessed portion and an insulation substrate having a mounting surface for an electronic component, in which the insulation substrate is located on a bottom surface of the recessed portion via a bonding material, and the bonding material is located within the insulation substrate when seen through an opening of the recessed portion in front perspective view.

An electronic device of the present disclosure includes the electronic component mounting package having the configuration described above and an electronic component mounted on the electronic component mounting package.

### Brief Description of Drawings

FIG. 1A is a top view illustrating an electronic component mounting package according to a first embodiment.
FIG. 1B is a bottom view illustrating the electronic component mounting package illustrated in FIG. 1A.
FIG. 2A is a cross-sectional view taken along line A-A of the electronic component mounting package illustrated in FIG. 1A.
FIG. 2B is an enlarged cross-sectional view of a major part in a portion A in FIG. 2A.
FIG. 3 is a cross-sectional view illustrating an electronic device with an electronic component mounted on the electronic component mounting package illustrated in FIGS. 1A and 1B.
FIG. 4A is a cross-sectional view illustrating another example of the electronic component mounting package according to the first embodiment.
FIG. 4B is an enlarged cross-sectional view of a major part in a portion A in FIG. 4A.
FIG. 5A is a cross-sectional view illustrating another example of the electronic component mounting package according to the first embodiment.
FIG. 5B is an enlarged cross-sectional view illustrating a major part of a portion A of FIG. 5A.
FIG. 6A is a top view illustrating an electronic component mounting package according to a second embodiment.
FIG. 6B is a top view illustrating a metal substrate of the electronic component mounting package illustrated in FIG. 6A.
FIG. 7A is a cross-sectional view taken along line A-A of the electronic component mounting package illustrated in FIG. 6A.
FIG. 7B is an enlarged cross-sectional view of a major part in a portion A in FIG. 7A.
FIG. 8A is a cross-sectional view illustrating an electronic component mounting package according to a third embodiment.
FIG. 8B is an enlarged cross-sectional view of a major part in a portion A in FIG. 8A.

### Description of Embodiments

Several exemplary embodiments of the present disclosure will be described with reference to the accompanying drawings.

### First Embodiment

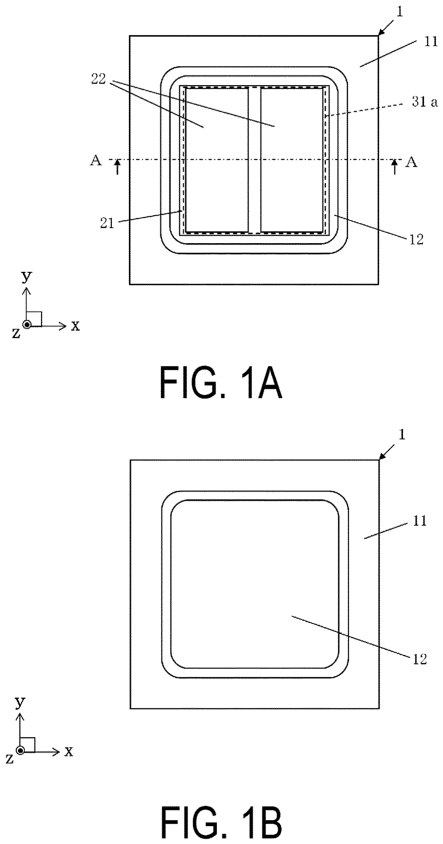

An electronic component mounting package 1 according to the present embodiment includes a metal substrate 11 having a recessed portion 12 and an insulation substrate 21 having a mounting surface for an electronic component 2. The insulation substrate 21 is located on a bottom surface 12a of the recessed portion 12 via a bonding material 31. The bonding material 31 is located within the insulation substrate 21 when seen through the opening of the recessed portion 12 in front perspective view. The insulation substrate 21 includes a wiring layer 22 located on a third surface described below and a joint layer 23 located on a fourth surface described below. In FIGS. 1A to 2B, an upward direction is a positive direction along a virtual z-axis. The distinction between upper and lower in the following description is for convenience only and should not be construed as a limitation in the vertical direction in the actual use of the electronic component mounting package 1 or the like.

The metal substrate 11 has a first surface (top surface in FIGS. 1A to 2B), a second surface (bottom surface in FIGS. 1A to 2B) located opposite to the first surface in a thickness direction, and side surfaces. The metal substrate 11 is made of a material having a high thermal conductivity, which is, for example, a metal material such as aluminum (Al), copper (Cu), or copper-tungsten (Cu-W). When the electronic component mounting package 1 is applied to an automobile headlight or the like, the metal substrate 11 may be made from aluminum as it has a good reflectivity with respect to a light emitting element for ultraviolet (UV) and is lightweight.

As illustrated in FIGS. 1A to 2B, the metal substrate 11 has the recessed portion 12 having a frame-like shape, being open to a first surface, and including a bottom surface 12a, and inner and outer surfaces. The recessed portion 12 serves as an indicator for mounting and supporting the insulation substrate 21 on the bottom surface 12a of the recessed portion 12. The recessed portion 12 is formed in the first surface of the metal substrate 11 by cutting, laser machining, or the like. For the metal substrate 11 made from copper (Cu) or copper-tungsten, it may be possible to deposit a metal film made from, for example, aluminum having an excellent reflectivity with respect to a light emitting element for UV on the inner surface of the recessed portion 12.

In the example illustrated in FIGS. 1A to 2B, the inner surface of the recessed portion 12 is inclined so that the opening side of the recessed portion 12 is wider than the bottom surface 12a side of the recessed portion 12 (space having a truncated square pyramid shape and having a larger opening on the first surface side of the metal substrate 11 in FIGS. 1A to 2B).

The insulation substrate 21 has a third surface (top surface in FIGS. 1A to 2B), a fourth surface (bottom surface in FIGS. 1A to 2B) on a side opposite to the third surface in a thickness direction, and side surfaces. The insulation substrate 21 includes a single insulation layer or a plurality of insulation layers, and has a rectangular shape when viewed in plan view, that is, when seen from a direction perpendicular to the third surface. The insulation substrate 21 functions as a support body for supporting the electronic component 2. The insulation substrate 21 includes a wiring layer 22 for mounting the electronic component 2 on the third surface side in plan view, and a joint layer 23 for bonding the metal substrate 11 on the fourth surface side in plan view.

The insulation substrate 21 may be made from a ceramic, such as an aluminum oxide-based sintered body (alumina ceramic), an aluminum nitride-based sintered body, a silicon nitride-based sintered body, a mullite-based sintered body, or a glass ceramic sintered body. The insulation substrate 21 may be made from a ceramic, such as an aluminum oxide-based sintered body (alumina ceramic), an aluminum nitride-based sintered body, a silicon nitride-based sintered body, a mullite-based sintered body, or a glass ceramic sintered body. In a case where the insulation substrate 21 is, for example, an aluminum nitride-based sintered body, a slurry is prepared by adding and mixing raw material powders, such as aluminum nitride (AlN), erbium oxide (Er₂O₃), yttrium oxide (Y₂O₃), or the like, with an appropriate organic binder, a solvent, and the like. A ceramic green sheet is produced by forming the slurry described above into a sheet using a known doctor blade method, calender roll method, or the like. If necessary, a plurality of ceramic green sheets are stacked and fired at a high temperature (approximately 1800°C) to produce the insulation substrate 21 formed of a single insulation layer or a plurality of insulation layers.

The wiring layer 22 is located on the third surface of the insulation substrate 21, as illustrated in FIGS. 1A to 2B. The wiring layer 22 is used as a connecting portion of a connection member 3 such as a solder bump or the like, and is used for electrically connecting the electronic component 2 and a connecting pad of a module substrate.

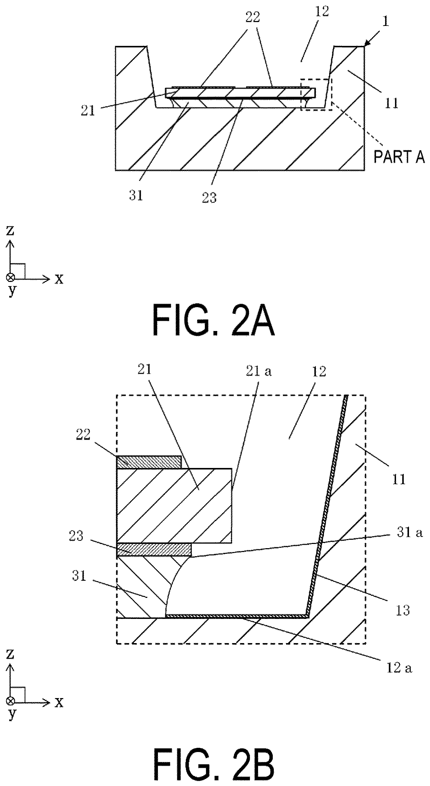

The joint layer 23 is located on the fourth surface of the insulation substrate 21, as illustrated in the example in FIGS. 2A and 2B. The joint layer 23 is used as a bonding portion such as a bonding material 31, and is used for bonding the metal substrate 11 and the insulation substrate 21 to each other.

The wiring layer 22 and the joint layer 23 include a thin film layer and a plating layer. The thin film layer includes, for example, an adhesion metal layer and a barrier layer. The adhesion metal layer constituting the thin film layer is formed on the third surface or the fourth surface of the insulation substrate 21. The adhesion metal layer is made from, for example, tantalum nitride, nickel-chromium, nickel-chromium-silicon, tungsten-silicon, molybdenum-silicon, tungsten, molybdenum, titanium, or chromium, and is deposited on the third surface or the fourth surface of the insulation substrate 21 by employing a thin film formation technique such as vapor deposition, ion plating, or sputtering. For example, in the case of forming the adhesion metal layer using a vacuum vapor deposition method, the insulation substrate 21 is placed in a deposition chamber of a vacuum deposition apparatus, and a metal piece to serve as the adhesion metal layer is disposed on the deposition source in the deposition chamber. Thereafter, the deposition chamber is brought into a vacuum state (pressure of 10⁻² Pa or less), and the metal piece disposed on the deposition source is heated and vaporized so that molecules of the vaporized metal piece are deposited on the insulation substrate 21, thereby forming a layer of thin film metal that serves as the adhesion metal layer. Then, after forming a resist pattern, using a photolithography method, on the insulation substrate 21 on which the layer of thin film metal is formed, an excess part of the layer of thin film metal is removed by etching to form the adhesion metal layer. The barrier layer is deposited on the top surface of the adhesion metal layer. The barrier layer has a good joining property and wettability with the adhesion metal layer and the plating layer, achieving strong bonding with the adhesion metal layer and the plating layer and preventing interdiffusion between the adhesion metal layer and the plating layer. The barrier layer is made from, for example, nickel-chromium, platinum, palladium, nickel, or cobalt, and is deposited on a surface of the adhesion metal layer by a thin film formation technique such as vapor deposition, ion plating, or sputtering.

Preferably, the thickness of the adhesion metal layer is approximately from 0.01 to 0.5 µm. A thickness of less than 0.01 µm tends to prevent the adhesion metal layer from strongly adhering on the metal substrate 11. A thickness of more than 0.5 µm tends to cause the adhesion metal layer to more easily peel off due to internal stress produced in the formation of the adhesion metal layer. Preferably, the thickness of the barrier layer is approximately from 0.05 to 1 µm. When the thickness is less than 0.05 µm, a flaw such as a pinhole is more likely to occur and the barrier layer is less likely to function properly. A thickness of more than 1 µm tends to cause the barrier layer to more easily peel off due to internal stress produced in the formation of the barrier layer.

The plating layer is deposited by an electroplating method or an electroless plating method on a surface where the thin film layer is exposed. The plating layer is made from a metal, such as nickel, copper, gold, or silver that has superior corrosion resistance and superior joining properties with the connection member 3. For example, a nickel plating layer having a thickness of approximately from 0.5 to 5 µm and a gold plating layer having a thickness of approximately from 0.1 to 3 µm are deposited in that order. This can effectively suppress corrosion of the wiring layer 22 and the joint layer 23 and strengthen bonding between the wiring layer 22 and the connection member 3 and bonding between the joint layer 23 and the metal substrate 11.

Furthermore, a metal layer such as copper (Cu) or gold (Au) may be disposed on the barrier layer so that the plating layer is favorably formed. The metal layer described above is formed by the same method as the thin film layer.

The bonding material 31 is located between the bottom surface 12a of the recessed portion 12 of the metal substrate 11 and the surface of the insulation substrate 21 opposite to the mounting surface, and bonds the bottom surface 12a of the recessed portion 12 of the metal substrate 11 and the joint layer 23 of the insulation substrate 21. As illustrated in the example illustrated in FIGS. 1A to 2B, the bonding material 31 is located within the insulation substrate 21 when seen through the opening of the recessed portion 12 in front perspective view. That is, an outer edge 31a of the bonding material 31 is located inside an outer edge 21a of the insulation substrate 21.

The metal substrate 11 includes a protective layer 13 on the inner surface of the recessed portion 12, as in the example illustrated in FIG. 2B. An end portion of the protective layer 13 on the inner side is located inside the outer edge 21a of the insulation substrate 21. The outer edge 31a of the bonding material 31 on the bottom surface 12a side of the recessed portion 12 is located so as to be in contact with the end portion of the protective layer 13 on the inner side, and the outer edge 31a of the bonding material 31 is located inside the outer edge 21a of the insulation substrate 21. In a configuration in which the metal substrate 11 is made of, for example, aluminum, the protective layer 13 is formed from, for example, aluminum oxide. The protective layer 13 is formed to have a thickness of approximately 0.1 nm to 10 nm. The protective layer 13 is provided such that, when the metal substrate 11 is made from, for example, copper (Cu) or copper-tungsten, a metal film such as aluminum which has a good reflectivity relative to the light emitting element for UV may be deposited on the inner surface of the recessed portion 12 to form the protective layer 13 on the surface of the metal film. The protective layer 13 may be provided over the entire inner surface of the recessed portion 12 so as to be used as a reflective surface with respect to the light emitting element for UV on the inner surface of the recessed portion 12.

For example, in a case where the metal substrate 11 is made from aluminum and the protective layer 13 is made from aluminum oxide, the protective layer 13 made from aluminum oxide is formed by oxidizing the inner surface (including the inner surface and the bottom surface 12a) of the recessed portion 12 of the metal substrate 11. After that, the protective layer 13 formed on the bottom surface 12a of the recessed portion 12 may then be removed. For example, after forming the recessed portion 12 on the surface of the metal substrate 11, the inner surface of the recessed portion 12 is oxidized to form the protective layer 13 made from aluminum oxide, and the bonding material 31 such as a solder is placed, for example, on the bottom surface 12a of the recessed portion 12. Subsequently, energy such as ultrasonic waves may be applied to the bottom surface 12a of the recessed portion 12 to remove the protective layer 13 from a part of the bottom surface 12a of the recessed portion 12. The bonding material 31 such as a solder may be placed on the bottom surface 12a of the recessed portion 12 so that, after the bonding material 31 is placed individually and the protective layer 13 is removed, the bonding material 31 is added so that the bonding materials 31 are bonded to each other.

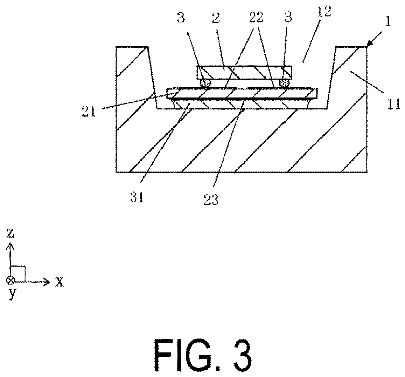

As illustrated in the example in FIG. 3, the electronic device can be produced by mounting the electronic component 2 on the third surface of the insulation substrate 21 of the electronic component mounting package 1. The electronic component 2 mounted on the electronic component mounting package 1 is, for example, a light emitting element such as a light emitting diode (LED) for UV. For example, in a case where the electronic component 2 is a flip-chip-type electronic component 2, the electronic component is mounted on the electronic component mounting package 1 by electrically and mechanically connecting electrodes of the electronic component 2 and the wiring layer 22 via the connection member 3 such as a solder bump, a gold bump, or a conductive resin (for example, an anisotropic conductive resin). For example, in a case where the electronic component 2 is a wire-bonding semiconductor element, the semiconductor element is fixed on the insulation substrate 21 with the connection member such as a low-melting point brazing material or a conductive resin and electrically connected to the electrodes of the semiconductor element and the wiring layer 22 via the connection member such as a bonding wire, and then mounted on the electronic component mounting package 1. As described above, the electronic component 2 is electrically connected to the wiring layer 22. When the bonding wire is used as the connection member, a bonding wire made of aluminum or the like may be used.

On the third surface of the insulation substrate 21, a plurality of electronic components 2 may be mounted. To mount the plurality of electronic components 2 on the insulation substrate 21, a region surrounding the plurality of electronic components 2 in plan view may be regarded as the mounting portion. Furthermore, where necessary, the electronic component 2 may be encapsulated with an encapsulation member made from a resin, glass, or the like, or with a lid made from a resin, glass, ceramic, metal, or the like.

The electronic component mounting package 1 according to the present embodiment includes the metal substrate 11 having the recessed portion 12 and the insulation substrate 21 having the mounting surface for the electronic component 2, in which the insulation substrate 21 is located on the bottom surface 12a of the recessed portion 12 via the bonding material 31, and the bonding material 31 is located within the insulation substrate 21 when seen through the opening of the recessed portion 12 in front perspective view. With the configuration described above, when the light emitting element for UV is mounted as the electronic component 2 and made to emit light, it is difficult for the emitted light to effectively irradiate the bonding material 31 made from a brazing material or the like, and the light reflected by the bonding material 31 made from the brazing material or the like having a low reflectivity is less likely emitted to the outside. As a result, the electronic component mounting package 1 capable of emitting favorable light can be provided.

Additionally, as illustrated in the example illustrated in FIGS. 1A to 2B, the bonding material 31 is located within the insulation substrate 21 over the entire circumference of the outer edge 31a of the bonding material 31, when seen through the opening of the recessed portion 12 in front perspective view. With the configuration described above, when the light emitting element for UV is mounted over the entire circumference of the recessed portion 12 and made to emit light, it is difficult for the emitted light to effectively irradiate the bonding material 31 made from the brazing material or the like, and the light reflected by the bonding material 31 made from the brazing material or the like having a low reflectivity is less likely emitted to the outside. As a result, the electronic component mounting package 1 capable of emitting favorable light can be provided.

The outer edge of the joint layer 23 is located away from the outer edge 21a of the insulation substrate 21 when seen through the opening of the recessed portion 12 in front perspective view, as illustrated in FIGS. 1A to 2B. With the configuration described above, it is difficult for the bonding material 31 to flow out to the outer edge of the insulation substrate 21, and it is further unlikely that the light from the light emitting element irradiates the bonding material 31 better, thus providing the electronic component mounting package 1 capable of emitting favorable light.

The outer edge of the joint layer 23 is located away from the outer edge 21a of the insulation substrate 21 over the entire circumference of the outer edge 31a of the bonding material 31 when seen through the opening of the recessed portion 12 in front perspective view. With the configuration described above, it is difficult for the bonding material 31 to flow out to the outer edge of the insulation substrate 21 over the entire circumference, and it is further unlikely that the light from the light emitting element irradiates the bonding material 31 better, thus providing the electronic component mounting package 1 capable of emitting favorable light.

Also, as illustrated in FIGS. 1A to 2B, the outer edge of the wiring layer 22 is located inside the outer edge 31a of the bonding material 31 when seen through the opening of the recessed portion 12 in front perspective view. With the configuration described above, the electronic component 2 mounted on the insulation substrate 21 can favorably transfer heat to the metal substrate 11 side via the wiring layer 22, the insulation substrate 21, the joint layer 23, and the bonding material 31. As a result, the electronic component mounting package 1 that can be used well for a long term can be provided.

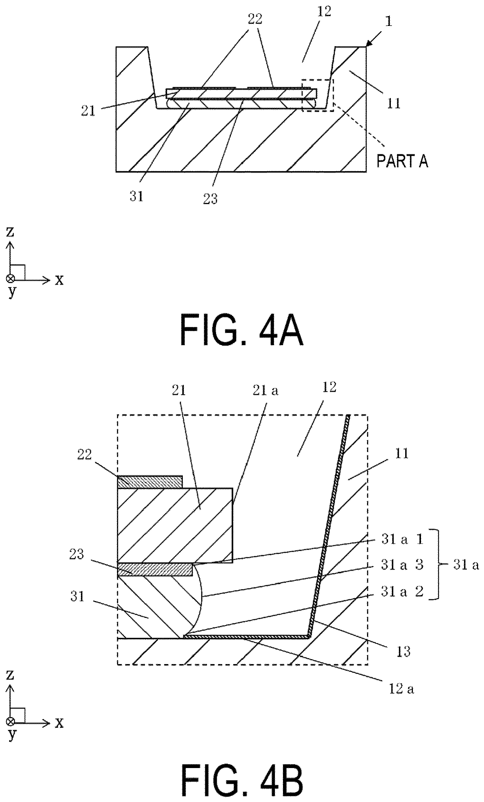

As illustrated in the example in FIGS. 4A and 4B, the bonding material 31 has a first outer edge 31a1 located near the insulation substrate 21, a second outer edge 31a2 located away from the insulation substrate 21, and a fifth outer edge 31a3 located between the first outer edge 31a1 and the second outer edge 31a2. The fifth outer edge 31a3 of the bonding material 31 is located outside the first outer edge 31a1 and the second outer edge 31a2. With the configuration described above, even when the bonding material 31 is irradiated with the light from the light emitting element, the emitted light irradiates the first outer edge 31a1 side, and the reflected light can be easily blocked by the insulation substrate 21. Also, the emitted light irradiates the second outer edge 31a2 side, and the reflected light easily irradiates the bottom surface 12a side of the recessed portion 12. Thus, it is difficult for the light that has irradiated and has been reflected by the bonding material 31 to reach the opening side of the recessed portion 12. As a result, the electronic component mounting package 1 capable of emitting favorable light can be provided. The fifth outer edge 31a3 may be located outside the outer edge of the wiring layer 22 and the end portion of the protective layer 13 on the inner side.

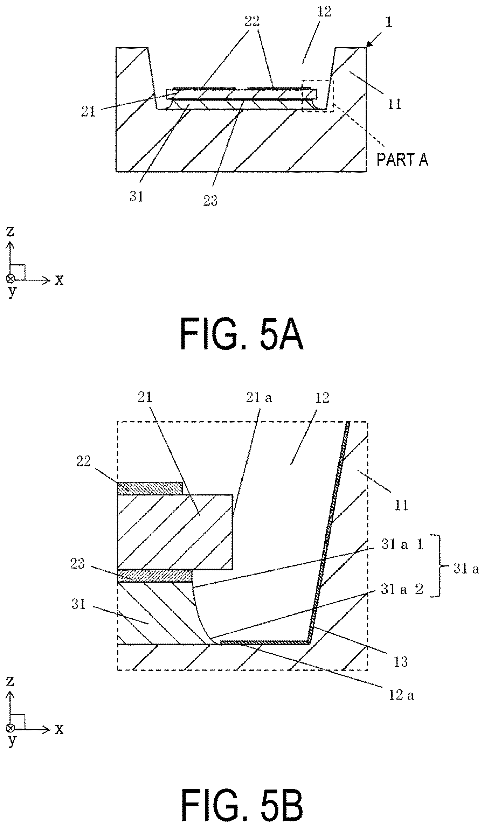

As in the example illustrated in FIGS. 5A and 5B, in the bonding material 31, the first outer edge 31a1 located near the insulation substrate 21 is located inside the second outer edge 31a2 located away from the insulation substrate 21. Here, the inside means a direction from an outer edge to a center of the electronic component mounting package 1 in front view. With the configuration described above, it is difficult for the bonding material 31 to flow out to the outer edge 21a of the insulation substrate 21, and it is further unlikely that the light from the light emitting element irradiates the bonding material 31 better. Also, the electronic component 2 mounted on the insulation substrate 21 can favorably transfer heat to the metal substrate 11 side via the wiring layer 22, the insulation substrate 21, the joint layer 23, and the bonding material 31. As a result, the electronic component mounting package 1 capable of emitting favorable light for a long term can be provided. In the joint layer 23, the first outer edge 31a1 located near the insulation substrate 21 over the entire circumference may be located inside the second outer edge 31a2 which is located away from the insulation substrate 21.

The wiring layer 22 of the electronic device is electrically connected to a wiring conductor of an external device or a connecting pad of a module sub strate.

In a case where the electronic device has a heat dissipation body made from Al or the like and bonded to a bottom surface of the electronic device, the electronic device can favorably dissipate heat from the electronic device to the heat dissipation body, thus providing the electronic device that can be used well for a long term.

The heat dissipation body may be provided such that, for example, a through hole is formed outside the bonding portion between the electronic device and the heat dissipation body in plan view, through which the electronic device is fixed to the external device by screwing, and the wiring layer 22 of the electronic device and a wiring conductor of the external device are electrically connected with a connecting material. Alternatively, the electronic device may be held on the module substrate, and the wiring layer 22 of the electronic device and the connecting pad of the module substrate may be electrically connected with the connecting material.

### Second Embodiment

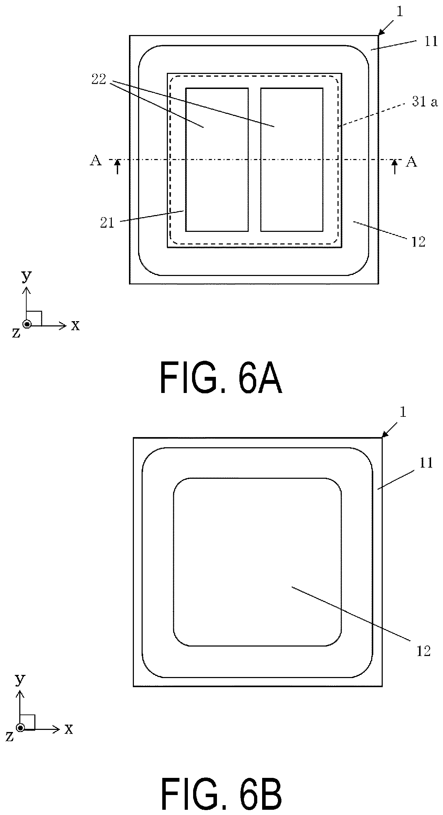

Next, an electronic component mounting package 1 according to a second embodiment will be described with reference to FIGS. 6A to 7B.

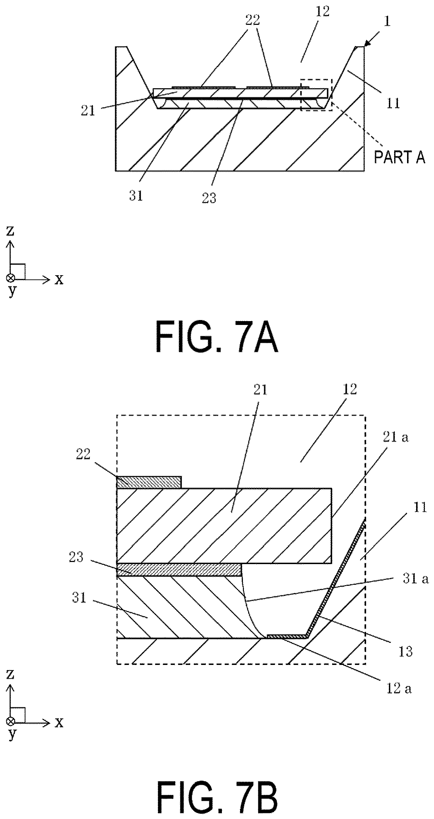

The electronic component mounting package 1 according to the second embodiment differs from the electronic component mounting package 1 of the above-described embodiment in that the outer edge 21a of the insulation substrate 21 is located outside the bottom surface 12a of the recessed portion 12 when seen through the opening of the recessed portion 12 in front perspective view. Here, outside means a direction away from the center of the electronic component mounting package 1 in front view. FIG. 7B illustrates an example in which the outer edge 21a of the insulation substrate 21 extends outside the boundary between the bottom surface 12a and the inner surface connected to the bottom surface 12a in the recessed portion 12. In a case where the connecting portion between the bottom surface 12a and the inner surface has a curved surface, the bottom surface 12a is defined as a portion where the thickness of the metal substrate 11, which includes the bottom surface 12a of the recessed portion 12, increases by up to 5% of the thickness of the metal substrate 11 at a portion where the bonding material 31 is present.

Similar to the electronic component mounting package 1 according to the above-described embodiment, the electronic component mounting package 1 according to the second embodiment is provided such that, when the light emitting element for UV is mounted as the electronic component 2 and made to emit light, it is difficult for the emitted light to effectively irradiate the bonding material 31 made from the brazing material or the like, and the light reflected by the bonding material 31 made from the brazing material or the like having a low reflectivity is less likely emitted to the outside. As a result, the electronic component mounting package 1 capable of emitting favorable light can be provided.

Furthermore, the outer edge 21a of the insulation substrate 21 is located outside the bottom surface 12a of the recessed portion 12 when seen through the opening of the recessed portion 12 in front perspective view. With the configuration described above, when the light emitting element for UV is mounted as the electronic component 2 and made to emit light, it is difficult for the emitted light to effectively irradiate the bonding material 31 made from the brazing material or the like, and it is further unlikely that the light reflected by the bonding material 31 made from the brazing material or the like having a low reflectivity is emitted to the outside. As a result, the electronic component mounting package 1 capable of emitting favorable light can be provided.

Similar to the electronic component mounting package 1 according to the first embodiment, the electronic component mounting package 1 according to the second embodiment is also provided such that the end portion of the protective layer 13 on the inner side overlaps the insulation substrate 21 when seen through the opening of the recessed portion 12 in front perspective view, thus making the bonding material 31 be located within the insulation substrate 21 when seen through the opening of the recessed portion 12 in front perspective view. In the above case, the end portion of the protective layer 13 on the inner side may be located on the bottom surface 12a of the recessed portion 12 or on the inner surface of the recessed portion 12 near the boundary with the bottom surface 12a of the recessed portion 12. When the end portion of the protective layer 13 on the inner side is located on the inner surface of the recessed portion 12 near the boundary with the bottom surface 12a of the recessed portion 12, it is bonded with the metal substrate 11 over the entire surface of the bottom surface 12a of the recessed portion 12, so that the electronic component 2 mounted on the insulation substrate 21 can transfer heat favorably to the metal substrate 11. As a result, the electronic component mounting package 1 that can be used well for a long term can be provided. In that case, an end portion of the protective layer 13 on the outer side may be located over the entire circumference of the inner surface of the recessed portion 12 on the opening side of the recessed portion 12.

In addition to the above-described method, the electronic component mounting package 1 according to the second embodiment can be manufactured using the same manufacturing method as that of the electronic component mounting package 1 of the above-described embodiment.

### Third Embodiment

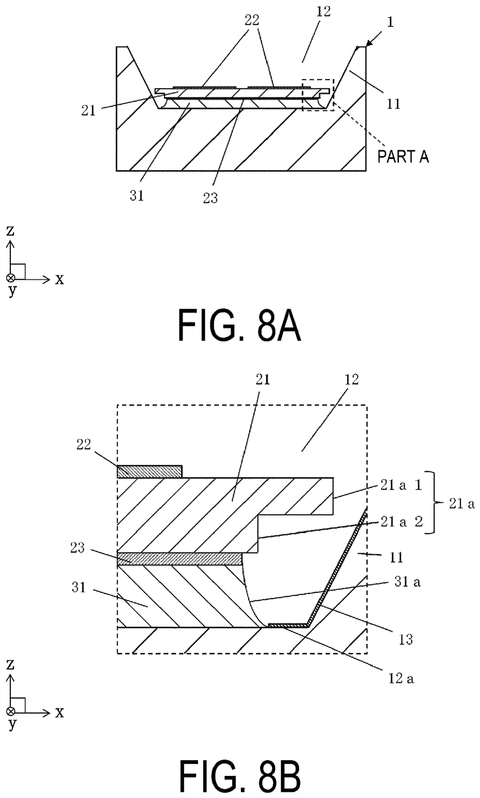

Next, an electronic component mounting package 1 according to a third embodiment will be described with reference to FIGS. 8A and 8B.

The electronic component mounting package 1 according to the third embodiment differs from the electronic component mounting package 1 of the above-described embodiment in that a third outer edge 21a1 which is the outer edge of the mounting surface (the top surface in FIGS. 8A and 8B) of the insulation substrate 21 is located outside a fourth outer edge 21a2 which is the outer edge of a surface opposite to the mounting surface (lower surface in FIGS. 8A and 8B). Here, outside means a direction away from the center of the electronic component mounting package 1 in a front view. The outer edge 21a of the insulation substrate 21 includes the third outer edge 21a1 and the fourth outer edge 21a2.

Similar to the electronic component mounting package 1 according to the above-described embodiment, the electronic component mounting package 1 according to the third embodiment is provided such that, when the light emitting element for UV is mounted as the electronic component 2 and made to emit light, it is difficult for the emitted light to effectively irradiate the bonding material 31 made from the brazing material or the like, and the light reflected by the bonding material 31 made from the brazing material or the like having a low reflectivity is less likely emitted effectively to the outside. As a result, the electronic component mounting package 1 capable of emitting favorable light can be provided.

Furthermore, the insulation substrate 21 is provided such that the third outer edge 21a1, which is the outer edge of the mounting surface, is located outside the fourth outer edge 21a2, which is the outer edge of the surface opposite to the mounting surface. With the configuration described above, when the light emitting element for UV is mounted as the electronic component 2 and made to emit light, it is difficult for the emitted light to effectively irradiate the bonding material 31 made from the brazing material or the like, and the light reflected by the bonding material 31 made from the brazing material or the like having a low reflectivity is less likely emitted effectively to the outside. As a result, the electronic component mounting package 1 capable of emitting favorable light can be provided. In the configuration described above, the outer edge 21a of the insulation substrate 21 may have a sloped portion, and as illustrated in FIGS. 8A and 8B, the outer edge 21a of the insulation substrate 21 may have a stepped portion. The outer edge 21a of the insulation substrate 21 having a stepped portion makes it difficult for the insulation substrate 21 to contact the inner surface of the recessed portion 12, allowing the third outer edge 21a1 to be located further outward and facilitating blockage of the emitted light by the third outer edge 21a1. Accordingly, it is difficult for the emitted light to effectively irradiate the bonding material 31 made from the brazing material or the like, and the light reflected by the bonding material 31 made from the brazing material or the like having a low reflectivity is less likely emitted effectively to the outside. In the above case, the third outer edge 21a1 can be located further outward from the bottom surface 12a in the recessed portion 12.

In the insulation substrate 21, the third outer edge 21a1 which is the outer edge of the mounting surface is located outside the fourth outer edge 21a2, which is the outer edge of the surface opposite to the mounting surface over the entire circumference of the outer edge 21a of the insulation substrate 21. With the configuration described above, even when the bonding material 31 flows out to the fourth outer edge 21a2, which is the outer edge of the surface opposite to the mounting surface, the bonding material 31 can be easily located in the insulation substrate 21 when seen through the opening of the recessed portion 12 in front perspective view. In particular, the bonding material 31 is provided such that, when the first outer edge 31a1 of the bonding material 31 located near the insulation substrate 21 is located inside the second outer edge 31a2, which is located away from the insulation substrate 21, the bonding material 31 can be easily located within the insulation substrate 21 when seen through the opening of the recessed portion 12 in front perspective view.

When seen through the opening of the recessed portion 12 in front perspective view, the electronic component 2 is located inside the fourth outer edge 21a2, which is the outer edge of the surface opposite to the mounting surface. With the configuration described above, the electronic component 2 mounted on the insulation substrate 21 can favorably transfer heat to the metal substrate 11 side via the wiring layer 22, the insulation substrate 21, the joint layer 23, and the bonding material 31. As a result, the electronic component mounting package 1 that can be used well for a long term can be provided.

In addition to the above method, the electronic component mounting package 1 according to the third embodiment can be manufactured using the same manufacturing method as that of the electronic component mounting package 1 of the above-described embodiments.

The present invention is not limited to the above-described embodiments, and various modifications are applicable. For example, the insulation substrate 21 may have a rectangular shape with a cut out portion or chamfer in a side surface or corner portion in plan view.

Furthermore, the recessed portion 12 is formed as a space having a truncated square pyramid shape and having a larger opening on the first surface side of the metal substrate 11 in the electronic component mounting package 1 of the first embodiment to the third electronic component mounting package 1; however, the recessed portion 12 may be formed as a space having a truncated cone shape and having a larger opening on the first surface side of the metal substrate 11. Alternatively, it may be formed as a rectangular parallelepiped space in the first surface of the metal substrate 11. Similar to the electronic component mounting package 1 of the first embodiment to the electronic component mounting package 1 of the third embodiment, the recessed portion 12 formed in the first surface of the metal substrate 11 and having a larger opening on the first surface side can emit favorable light from the light emitting element mounted on the insulation substrate 21.

Furthermore, the electronic component mounting package 1 according to the above-described embodiments includes one recessed portion 12 in the first surface of the metal substrate 11 and the insulation substrate 21 in the recessed portion 12. Alternatively, the electronic component mounting package 1 may include a plurality of recessed portions 12 formed in the first surface of the metal substrate 11 with each recessed portion 12 having the insulation substrate 21 bonded to the bottom surface 12a via the bonding material 31. In the above case, the electronic component 2 may be mounted on the insulation substrate 21 disposed on the bottom surface 12a of each recessed portion 12.

### Reference Signs List

1 Electronic component mounting package
11 Metal substrate
12 Recessed portion
13 Protective layer
21 Insulation substrate
21a Outer edge of insulation substrate
21a1 Third outer edge
21a2 Fourth outer edge
22 Wiring layer
23 Joint layer
31 Bonding material
31a Outer edge of bonding material
31a1 First outer edge
31a2 Second outer edge
2 Electronic component
3 Connection member

## Claims

1. An electronic component mounting package, comprising:
a metal substrate having a recessed portion; and
an insulation substrate having a mounting surface for an electronic component, wherein
the insulation substrate is located on a bottom surface of the recessed portion via a bonding material, and
the bonding material is located within the insulation substrate when seen through an opening of the recessed portion in front perspective view.

2. The electronic component mounting package according to claim 1, wherein
a first outer edge of the bonding material, which is located near the insulation substrate, is located inside a second outer edge, which is located away from the insulation substrate.

3. The electronic component mounting package according to claim 1 or 2, wherein
an outer edge of the insulation substrate is located outside the bottom surface of the recessed portion in front perspective view.

4. The electronic component mounting package according to any one of claims 1 to 3, wherein
a third outer edge of the insulation substrate, which is an outer edge of the mounting surface, is located outside a fourth outer edge, which is an outer edge of a surface opposite to the mounting surface.

5. An electronic device, comprising:
the electronic component mounting package according to any one of claims 1 to 4; and
an electronic component mounted on the electronic component mounting package.
